# EUROPÄISCHE PATENTSCHRIFT

(11) **EP 1 044 473 B1**
(45) Veröffentlichungstag und Bekanntmachung des Hinweises auf die Patenterteilung: **27.02.2008**
(21) Anmeldenummer: 99900041.7
(22) Anmeldetag: 08.01.1999
(51) Int. Cl.: H01L 23/051

(54) **NIEDERINDUKTIV ANGESTEUERTER, GATEGESTEUERTER THYRISTOR**
LOW-INDUCTANCE, GATE-CONTROLLED THYRISTOR
THYRISTOR COMMANDE PAR GACHETTE, A ATTAQUE PEU INDUCTIVE

(30) Priorität: 09.01.1998 DE 19800469
(43) Veröffentlichungstag der Anmeldung: 18.10.2000
(73) Patentinhaber: ABB Schweiz AG, 5400 Baden (CH)
(72) Erfinder: GRÜNING, Horst, CH-5430 Wettingen (CH); KELLER, Thomas, CH-5073 Frick (CH); KLAKA, Sven, CH-5415 Nussbaumen (CH); KLETT, Alexander, D-79774 Albbruck (DE); MAIBACH, Philippe, CH-5200 Brugg (CH); DEGARD, Björn, CH-5300 Turgi (CH); REES, Jochen, D-79761 Waldshut (DE)
(74) Vertreter: ABB Patent Attorneys
(86) Internationale Anmeldenummer: PCT/CH1999/000008
(87) Internationale Veröffentlichungsnummer: WO 1999/035687

(56) Entgegenhaltungen:
- WO-A-97/21248
- DE-A- 4 227 063
- US-A- 3 736 474
- PATENT ABSTRACTS OF JAPAN vol. 006, no. 251 (E-147), 10. Dezember 1982 & JP 57 148353 A (TOKYO SHIBAURA DENKI KK), 13. September 1982

## Beschreibung

### TECHNISCHES GEBIET

Die vorliegende Erfindung bezieht sich auf das Gebiet der Leistungshalbleitertechnik. Sie betrifft ein Halbleiterbauelement, insbesondere einen Thyristor, gemäss Oberbegriff des Patentanspruches 1 sowie ein Halbleiterbauteil gemäss Oberbegriff des Patentanspruches 4.

### STAND DER TECHNIK

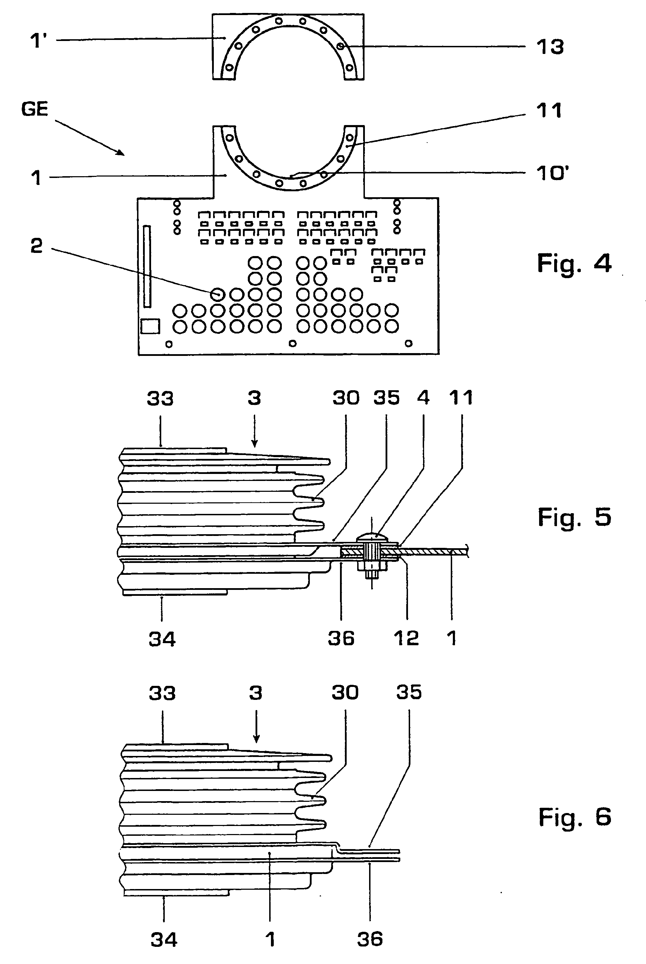

Gategesteuerte Thyristoren oder GCTs (Gate Controlled Thyristors) wie z.B. GTOs werden in manchen anspruchsvollen Anwendungen speziell niederinduktiv angesteuert (siehe dazu beispielsweise einen Artikel von P. Steiner, H. Grüning et al., "Serienschaltung von GTO-Thyristoren für Frequenzumrichter hoher Leistung", ABB Technik 5/1996, S.14-20, insbesondere Fig. 5). Zur niederinduktiven Verbindung zwischen dem Bauelement und der auf einer Anschlussplatine befindlichen Ansteuerschaltung wurde in einer älteren, nicht vorveröffentlichten Patentanmeldungein Gehäuse mit einem koaxialen Gateanschluss vorgeschlagen, welches eine Uebergangsinduktivität von < 1nH zwischen dem GCT und der Anschlussplatine ermöglicht. In dem Vorschlag wird die Kathode des GCT über ein vom GCT getrenntes Blech, z.B. in Form einer durchgehenden Bodenplatte der Gate-Unit, kontaktiert. Die Montage des GCT wird dadurch einfach:
- Auf die Bodenplatte mit Ring wird die Anschlussplatine der Gate-Unit gelegt;
- darauf kommt der Gateanschluss des GCT, indem der GCT mit seinem Gehäuse in die entstandene Wanne gelegt wird;
- mit Schrauben wird die Mehrlagenanordnung aus Bodenplatte/Ring, Anschlussplatine und GCT-Gateanschluss an verschiedenen Stellen verschraubt. Damit werden die Verbindungen von Platine zu Gate und Kathode des GCT hergestellt.

Eine andere, verbesserte Ausführungsform vermeidet die kostspielige Anordnung aus grossflächiger, eng tolerierter und vernickelter Bodenplatte und Ring, indem beides durch eine tiefgezogene Wanne ersetzt wird. Damit kann eine signifikante Vereinfachung der Herstellung erreicht werden.

Beide Varianten haftet jedoch ein thermischer Nachteil an: Das Blech der Kathodenwanne liegt zwischen dem Kathodenflansch und dem Kühler und bildet somit einen zweiten, weiteren Uebergang für die aus dem GCT austretende und abzuführende Wärme. Speziell in Systemen, bei denen es auf effiziente Kühlung ankommt, führt das zu einer deutlichen (> 5%) Reduktion der Gesamtsystemleistung.

Ferner offenbart WO 97/21248 einen GTO mit einem in einem Gehäuse angeordneten Halbleitersubstrat, einer Anode, einer Kathode, einem Gateanschluss und einem Hilfskathodenanschluss. Dabei ist der Hilfskathodenanschluss als Rohr ausgebildet, dessen innerer Hohlraum eine Zuleitung für den Gateanschluss bildet.

DE-A-42'27'063 zeigt einen GTO mit einem Gateelektrodenflansch, welcher einem Gehäuse vorsteht. Die Verbindung des GTO mit einer Gate-Unit erfolgt über einen Bandleiter, welcher auf einer Seite mit dem Gateelektrodenflansch verbunden ist und auf der anderen Seite durch einen Kathodenstempel kontaktiert wird.

### DARSTELLUNG DER ERFINDUNG

Es ist daher Aufgabe der Erfindung, ein Halbleiterbauelement sowie ein Halbleiterbauteil der eingangs genannten Art zu schaffen, welche die beschriebenen Nachteile nicht aufweisen, und sich insbesondere bei einfachem Aufbau und leichter Montage kathodm-nseitig durch einen stark verbesserten Wärmeübergang auszeichnen.

Die Aufgabe wird durch ein Halbleiterbauelement, insbesondere einen Thyristor, mit den Merkmalen des Patentanspruches 1 sowie durch ein Halbleiterbauteil mit den Merkmalen des Patentanspruches 4 gelöst.

Das erfindungsgemässe Halbleiterbauelement beziehungsweise das Halbleiterbauteil, bestehend aus Gateeinheit und Halbleiterbauelement, ermöglichen eine niederinduktive Verbindung zwischen Gateeinheit und Isolationsgehäuse des Halbleiterbauelementes. Eine Wanne zur Erstellung zur Kontaktierung der Kathode ist nicht mehr notwendig, da direkt am Gehäuse eine Hilfskathode angeordnet ist. Dies wird dadurch erreicht, dass beim Halbleiterbauelement sowohl Gateanschluss wie auch ein Hilfskathodenanschluss aus je einem dem Isolationsgehäuse vorstehenden Flansch bestehen, welche im montierten Zustand des Halbleiterbauelementes eine Leiterplatte oder Anschlussplatine der Gateeinheit umschliessen. Der Gateanschluss und der Hilfskathodenanschluss bilden somit ein Paar vorzugsweise parallel übereinanderliegender Ringe, zwischen denen im montierten Zustand des Thyristors die Anschlussplatine an das Gehäuse des Thyristors heranreicht. Hierdurch können niederinduktive ringförmige Anschlüsse in Form von vorstehenden Flanschen zwischen Gate bzw. Kathode und der Anschlussplatine realisiert werden. Die Kathode selbst bleibt davon unbeeinflusst und kann ohne thermische Beeinträchtigung in direkten Kontakt mit dem Kühlkörper gebracht werden.

Die Montage lässt sich durch spezielle Formgebung der Leiterplatte beziehungsweise des Halbleiterbauelementes vereinfachen. In einer ersten Ausführungsform verfügt die Leiterplatte über einen konkaven Einschnitt, welcher sich in den durch die zwei Flansche gebildeten Spalt einschieben lässt. In weiteren Ausführungsformen sind, damit der Thyristor bei der Montage ohne Schwierigkeiten und ohne Eingriffe in die Anschlusskonfiguration die Anschlussplatine zwischen Hilfskathodenanschluss und Gateanschluss nehmen kann, spezielle Montagemittel an einer Montageöffnung der Leiterplatte und den Anschlüssen des Thyristors vorgesehen.

Eine erste bevorzugte Ausführungsform der Erfindung zeichnet sich dadurch aus, dass die Mittel so ausgebildet sind, dass der Thyristor mit der Gehäuseachse senkrecht zur Anschlussplatine orientiert in die Montageöffnung eingesteckt und durch eine Drehung um die Gehäuseachse in die Anschlussposition gebracht werden kann. Die Montage ist bei dieser Ausführungsform besonders einfach, während die Montagemittel vergleichsweise aufwendig gestaltet sein müssen. Bevorzugt ist der Hilfskathodenanschluss und/oder der Gateanschluss in eine Mehrzahl von über den Umfang verteilt angeordneten, durch erste Aussparungen untereinander getrennten Segmenten unterteilt, und die Montageöffnung umfasst über den inneren Umfang verteilt angeordnete und nach Anzahl und Abmessungen den Segmenten entsprechende, segmentförmige zweite Aussparungen. Bei der Montage wird der Thyristor mit den Segmenten durch die zweiten Aussparungen hindurchgesteckt, bis die Anschlussplatine zwischen den Anschlüssen liegt, und anschliessend verdrent, bis die Segmente über bzw. unter den Bereichen zwischen den zweiten Aussparungen zu liegen kommen und dort an die Anschlussplatine angeschlossen werden können.

Eine zweite bevorzugte Ausführungsform der Erfindung ist dadurch gekennzeichnet, dass die Mittel so ausgebildet sind, dass der Thyristor mit schräg zur Anschlussplatine orientierter Gehäuseachse in die Montageöffnung eingedreht werden kann. Bei dieser Ausführungsform sind die Montagemittel besonders einfach ausgebildet, während die Montage selbst etwas mehr Geschicklichkeit erfordert. Bevorzugt weist der Hilfskathodenanschluss und/oder der Gateanschluss an seinem Umfang wenigstens eine segment- oder schlitzförmige erste Aussparung auf, und weist die Montageöffnung an ihrem inneren Umfang wenigstens eine segment- oder schlitzförmige zweite Aussparung auf.

Vorteilhaft bei der Verwendung eines segment- oder schlitzförmigen Aussparung ist, dass die Anschlussplatine lediglich eine geringe Unterbrechung aufweist. Dadurch wird die Gatestromsteilheit optimiert.

Die Montagemittel (Segmente bzw. Aussparungen) können am Hilfskathodenanschluss alleine, am Gateanschluss alleine, oder an beiden Anschlüssen vorhanden sein. Im ersten Fall muss der Thyristor (von oben) mit der Kathodenseite zuerst in die Montageöffnung eingeführt werden. Im zweiten Fall muss der Thyristor (von unten) mit der Anodenseite zuerst in die Montageöffnung eingeführt werden. Im dritten und letzten Fall kann das Einsetzen wahlweise von einer der beiden Seiten erfolgen.

Im allgemeinen werden derartige Halbleiterbauteile bestehend aus je einer Gateeinheit mit darin angeordnetem Halbleiterbauelement übereinander gestapelt eingesetzt. Beim erfindungsgemässen Halbleiterbauteil ist vorteilhaft, dass bei Defekt eines Halbleiterbauelementes nicht der gesamte Stapel auseinandergenommen werden muss, um das defekte Element auszuwechseln.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: eine perspektivische Darstellung eines erfindungsgemässen Halbleiterbauteils mit einem eingebauten Halbleiterbauelement;
- Figur 2a: ein Halbleiterbauelement in perspektivischer Ansicht gemäss einem Ausführungsbeispiel der Erfindung (ohne Darstellung der Montagemittel);
- Fig. 2b: den in die Anschlussplatine eingesetzten Thyristor aus Fig. 2a in der Seitenansicht;
- Figur 2c: eine Seitenansicht einer zweiten Ausführungsform des erfindungsgemässen Halbleiterbauelementes;
- Figur 3a: einen Querschnitt durch das Halbleiterbauelement gemäss Figur 2c;
- Figur 3b: einen Teilschnitt durch eine dritte Ausführungsform;
- Figur 4: eine Gateeinheit gemäss der Erfindung;
- Figur 5: eine vergrösserte Teilansicht eines montierten Halbleiterbauelementes gemäss der zweiten Ausführungsform;
- Figur 6: eine vergrösserte Teilansicht einer vierten Ausführungsform eines Halbleiterbauelementes.
- Fig. 7a: in der Draufsicht von oben ein fünftes bevorzugtes Ausführungsbeispiel für einen Thyristor nach der Erfindung mit Montagemitteln in Form segmentierter Anschlüsse;
- Fig. 7b: die zu dem Thyristor nach Fig. 7a passenden Montagemittel in Form segmentartiger Aussparungen an der Anschlussplatine;
- Fig. 7c: in der Draufsicht von oben den Thyristor nach Fig. 7a nach dem Einsetzen in Achsenrichtung in die Anschlussplatine;
- Fig. 7d: die Konfiguration gemäss Fig. 7c nach dem Drehen des Thyristors in der Montageöffnung;
- Fig. 8a: in der Draufsicht von oben ein sechstes bevorzugtes Ausführungsbeispiel für einen Thyristor nach der Erfindung mit Montagemitteln in Form einer segmentartigen Aussparung in den Anschlüssen;
- Fig. 8b: die zu dem Thyristor nach Fig. 8a passenden Montagemittel in Form einer segmentartigen Aussparung an der Anschlussplatine;
- Fig. 8c: in der Draufsicht von unten den Thyristor nach Fig. 8a vor dem Einfädeln des Kathodenanschlussringes in die Aussparung an der Anschlussplatine;
- Fig. 8d3: in der Draufsicht von unten den Thyristor nach Fig. 8a nach dem Einfädeln des Kathodenanschlussringes in die Aussparung an der Anschlussplatine;
- Figur 9a: in der Draufsicht von oben ein siebtes bevorzugtes Ausführungsbeispiel für einen Thyristor nach der Erfindung mit Montagemitteln in Form eines Schlitzes im Hilfskathodenanschluss; und
- Fig. 9b: die zu dem Thyristor nach Fig. 9a passenden Montagemittel in Form eines Schlitzes an der Anschlussplatine;

### WEGE ZUR AUSFÜHRUNG DER ERFINDUNG

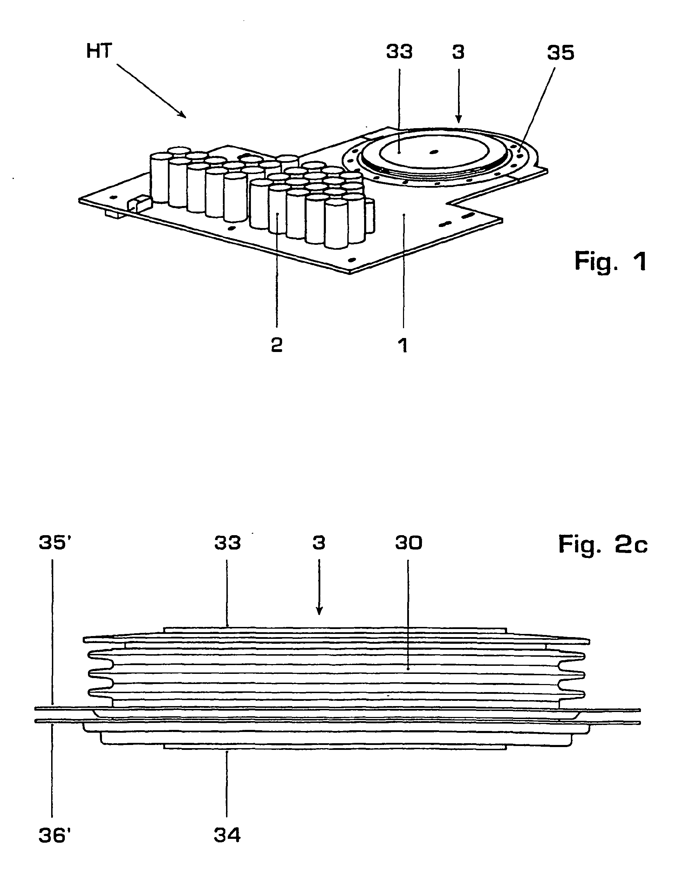

In Figur 1 ist ein Halbleiterbauteil HT gemäss der Erfindung dargestellt. Das Halbleiterbauteil HT besteht aus einer Gateeinheit GE, mit einer Leiterplatte , auch Anschlussplatine 1 genannt, und darauf angeordneten elektrischen Bauteilen 2, sowie einem in der Anschlussplatine 1 gehaltenen Hochleistungs-Halbleiterbauelement 3.

Die Anschlussplatine 1 ist im allgemeinen mehrschichtig aufgebaut. Mindestens ein Teil der elektrischen Bauteile 2 dient zur Steuerung des Gates und besteht beispielsweise aus Kondensatoren.

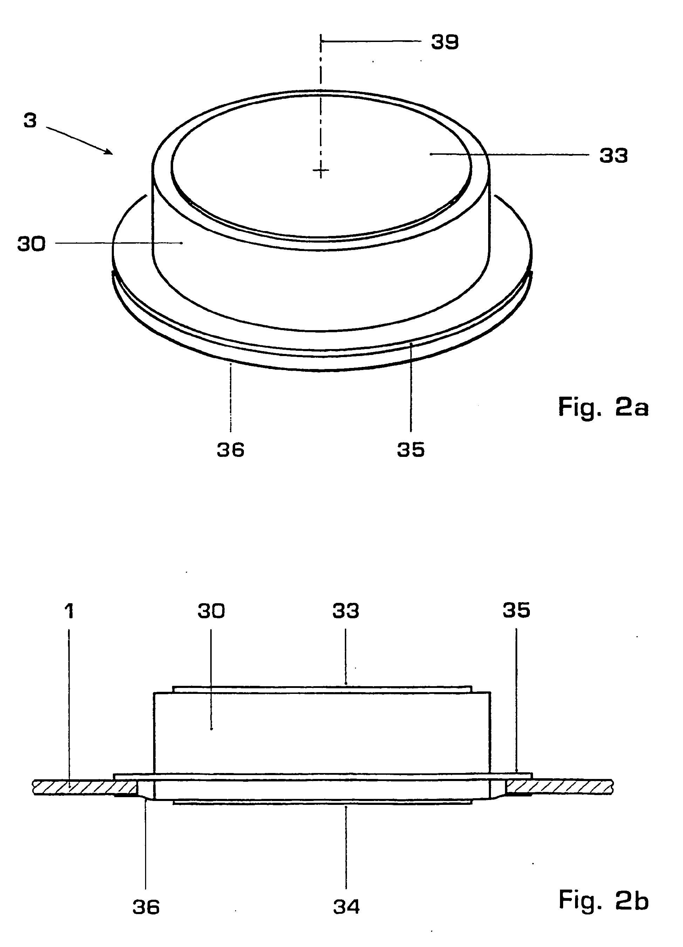

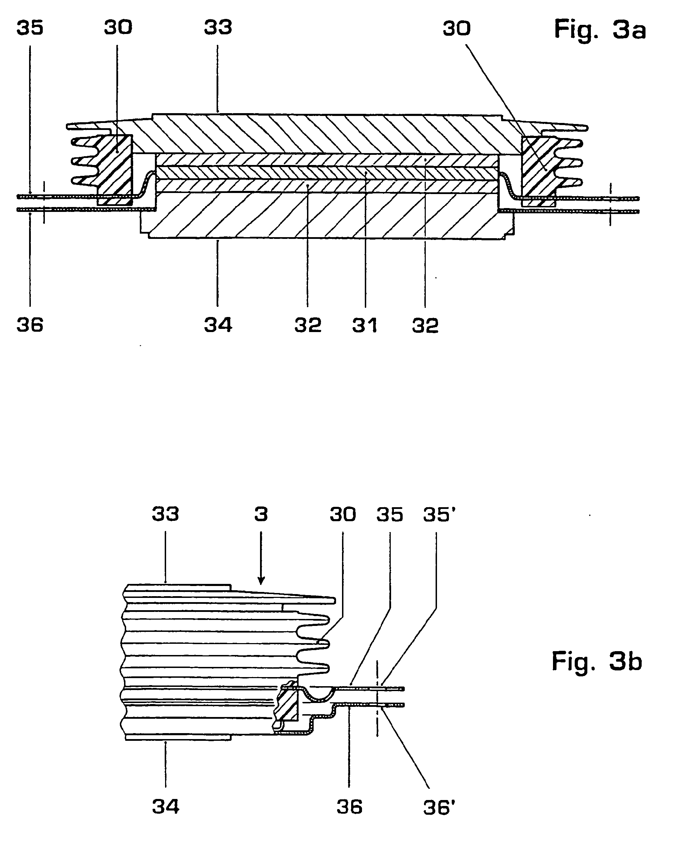

In Fig. 2a ist in perspektivischer Ansicht ein Halbleiterbauelement in Form eines Thyristors gemäss einem Ausführungsbeispiel der Erfindung wiedergegeben. Der gategesteuerte Thyristor 33 umfasst ein (in Figur 3a sichtbares) Halbleitersubstrat 31 auf Si-Basis, auf welchem in bekannter Weise eine Vielzahl von Einzelelementen nebeneinander angeordnet sind.

Vorzugsweise ist das Halbleitersubstrat 31 zwischen zwei Molybdän-Scheiben 32 eingebettet. Das Halbleitersubstrat 31 ist in einem hermetisch abgeschlossenen Isoliergehäuse 30 untergebracht. Das Gehäuse 30 ist im Beispiel rotationssymmetrisch um eine Gehäuseachse 39. Es besteht aus einem zylindrischen Seitenteil, welches üblicherweise aus einer Keramik hergestellt ist und zur Verlängerung des Kriechweges ein (in Fig. 2c gezeigtes) wellenförmiges Profil aufweist. An den Stirnseiten des Gehäuses 30 sind - wie auch aus der Seitenansicht in Fig. 2b erkennbar ist - eine kreisförmige, grossflächige Anode 33 (obere Stirnseite) und eine entsprechende Kathode 34 (untere Stirnseite) angeordnet, über welche der Thyristor 33 in einem unter axialem Pressdruck stehenden Einbaustapel elektrisch und thermisch an benachbarte Kühldosen angekoppelt wird.

In einer Ebene zwischen der Anode 33 und der Kathode 34 ragt seitlich aus dem Gehäuse 30 ein das Gehäuse 30 konzentrisch umgebender, kreisringförmiger Gateanschluss 35 heraus, welcher einen dem Gehäuse 30 radial vorstehenden Gateelektroden-Flansch bildetVorzugsweise formt der Gateelektroden-Flansch mindestens annähernd einen Vollkreis, wobei er über den Umfang verteilte erste Schraublöcher 35' aufweist.

Parallel zum Gateanschluss 35 liegt in einer Ebene unterhalb des Gateanschlusses 35 ein Hilfskathodenanschluss 36, der als seitlich und über das Gehäuse 30 hinausragender, die Kathode 34 umgebender, konzentrischer Kreisring ausgebildet ist und einen Hilfskathoden-Flansch bildet. Der Hilfskathoden-Flansch weist mehrere zweite Schraublöcher 36' auf, welche mit den ersten Schraublöchern 35' des Gateelektroden-Flansches fluchten.

Gateanschluss 35 und Hilfskathodenanschluss 36 bestehen aus je einem Metallring, welche vorzugsweise hartverlötet sind. Ausserhalb des Gehäuses 30 verlaufen die Anschlüsse mindestens annähernd parallel zueinander, wobei mindestens der das Gehäuse 30 überragende Teil des einen und/oder des anderen Anschlusses 35,36 planar ausgebildet ist. Vorzugsweise weisen beide Anschlüsse 35,36 denselben Aussenradius auf.

In Figur 3b ist eine dritte Ausführungsform dargestellt. In diesem Fall verlaufen die Anschlüsse ausserhalb des Gehäuses 30 nicht sofort planar zueinander, sondern weisen Kröpfungen und/oder Einbuchtungen auf.

In den in den Figuren 2c und 3b dargestellten Ausführungsformen besitzen beide Anschlüsse 35,36 mindestens annähernd dieselbe Dicke. Diese Dicke ist dabei so gewählt, dass der elektrische Widerstand einer Leiterschleife um das Gehäuse 30 herum deutlich kleiner ist als der Gesamtwiderstand des Gatekreises. Typische Werte für die Dicke eines Flansches sind 0.3 - 0.5 mm

Der Abstand zwischen dem Gateanschluss 35 und dem Hilfskathodenanschluss 36 ist relativ klein. Er wird so gewählt, dass die Induktivität einer Leiterschleife um das Gehäuse 30 herum deutlich kleiner ist als die Gesamtinduktivität des Gatekreises. Typische Werte sind 1 - 2.5 mm, vorzugsweise mindestens annähernd 1.8 mm. Dieser Abstand hängt jedoch nicht nur von den gewünschten elektrischen Eigenschaften ab, sondern auch auf von der Dicke der Anschlussplatine 1 der zugehörigen Gateeinheit GE, wie im folgenden dargelegt wird.

Wie aus den Figuren 1 und 2b zu ersehen ist, wird der Thyristor 33 zur niederinduktiven Ansteuerung auf spezielle Weise mit einer auf der Anschlussplatine 1 untergebrachten Ansteuerschaltung verbunden. Dies geschieht dadurch, dass der Thyristor 33 in eine in der Anschlussplatine 1 vorgesehene, kreisrunde Montageöffnung 10 eingesetzt wird. Der Innendurchmesser der Montageöffnung 10 ist deutlich kleiner als die Aussendurchmesser von Gateanschluss 35 und Hilfskathodenanschluss 36. Dadurch überlappen beide Anschlüsse 35, 36 die Anschlussplatine 1 am Rand der Montageöffnung und können über ihren gesamten Umfang direkt und niederinduktiv mit der Anschlussplatine 1 bzw. den auf beiden Seiten der Anschlussplatine 1 vorhandenen Leiterbahnen verbunden werden.

Der Abstand zwischen dem Gateanschluss 35 und dem Hilfskathodenanschluss 36 ist so gewählt, dass- wie in Fig. 2b gezeigt - die Anschlussplatine 1 mit ihrer Platinendicke zwischen beiden Platz hat. Da der Hilfskathodenanschluss 36 die Kathode 34 ringförmig umgibt, liegt beim im Stapel eingebauten Thyristor 3 die Kühldose direkt an der Kathode an, so dass die beim Einsatz einer Kathodenwanne im Stand der Technik auftretenden Probleme entfallen. Andererseits muss die Anschlussplatine 1 jedoch auf irgendeine Art und Weise zwischen die beiden Anschlüsse 35 und 36 gebracht werden, damit die Oberseite der Platine direkt mit dem Gateanschluss 35 und die Unterseite der Platine direkt mit dem Hilfskathodenanschluss 36 in Kontakt gebracht werden kann.

In Figur 4 ist ein erste Variante dargestellt, um das Halbleiterbauelement in die Anschlussplatine 1 der Gateeinheit GE zu befestigen. Zur Aufnahme des erfindungsgemässen Thyristors 3 weist die Anschlussplatine 1 eine Öffnung auf, welche durch einen konkaven, vorzugsweise halbkreisförmigen Einschnitt 10' in der Anschlussplatine 1 gebildet ist. Entlang dieses Einschnittes 10' ist auf einer ersten Oberfläche eine erste halbkreisförmige metallisierte Kontaktfläche 11 zur elektrischen Kontaktierung des Gateelektroden-Flansches 35 vorhanden. Auf einer gegenüberliegenden zweiten Oberfläche ist eine zweite halbkreisförmige metallisierte Kontaktfläche 12 angebracht, welche zur Kontaktierung des Hilfskathoden-Flansches 36 dient. Mindestens im Bereich dieser Kontaktflächen 11,12 weist die Anschlussplatine 1 inklusive der Kontaktflächen 11, 12 eine Dicke auf, welche mindestens annähernd dem Abstand zwischen dem Gateanschluss 35 und dem Hilfskathodenanschluss 36 entspricht. Die zwei Kontaktflächen 11,12 sind von Befestigungsbohrungen 13 durchsetzt, welche im gleichen Abstand angeordnet sind wie die Schraublöcher 35',36' der zwei Anschlüsse 35,36.

Bei der Montage des Thyristors 3 in beziehungsweise an die Gateeinheit GE wird der Thyristor 3 auf die Anschlussplatine 1 aufgesteckt, indem der Einschnitt 10 der Anschlussplatine 1 zwischen den Flansch des Gateanschlusses 35 und dem Flansch des Hilfskathodenanschlusses 36 geschoben wird. Mittels elektrisch isolierter Befestigungsschrauben 4, welche die Schraublöcher 35',36' und die Befestigungsbohrungen 13 durchdringen, wird das aufgesteckte Halbleiterbauelement 3 anschliessend an der Anschlussplatine 1 befestigt, wie dies in Figur 5 dargestellt ist.

Vorteilhafterweise ist, wie in Figur 4 dargestellt, eine Abschlussplatte 1' vorhanden, welche das Gegenstück zur oben beschriebenen Anschlussplatine 1 bildet und nach dem Aufstecken des Thyristors 3 an die einschnittseitige Stirnfläche der Anschlussplatine 1 angefügt wird. Dabei wird auch die Abschlussplatte 1' zwischen die zwei Flansche 35,36 geschoben und mittels Befestigungsschrauben fixiert. Abschlussplatte 1' und Anschlussplatine 1 bilden dadurch eine runde Öffnung, in welcher das Halbleiterbauelement 3 gehalten ist. Vorzugsweise weist die Abschlussplatte 1' ebenfalls Kontaktflächen zur Kontaktierung des Gate- und des Hilfskathodenanschlusses 35,36 auf, um die Gesamtinduktivität zu verringern und die Abschaltfähigkeit zu erhöhen. Als Abschlussplatte 1' wird vorzugsweise das bei der Fabrikation des Einschnittes 10 der Anschlussplatine 1 abgeschnittene Stück verwendet.

Prinzipiell ist eine derartige Abschlussplatte 1' jedoch nicht notwendig. Bei Verzicht auf diese Abschlussplatte 1' ist es vorteilhaft, die Flansche 35,36 in ihrem freien Bereich tiefzuziehen, wie dies in Figur 6 dargestellt ist. Dadurch wird der Abstand zwischen den Anschlüssen und somit die Gesamtinduktivität verringert.

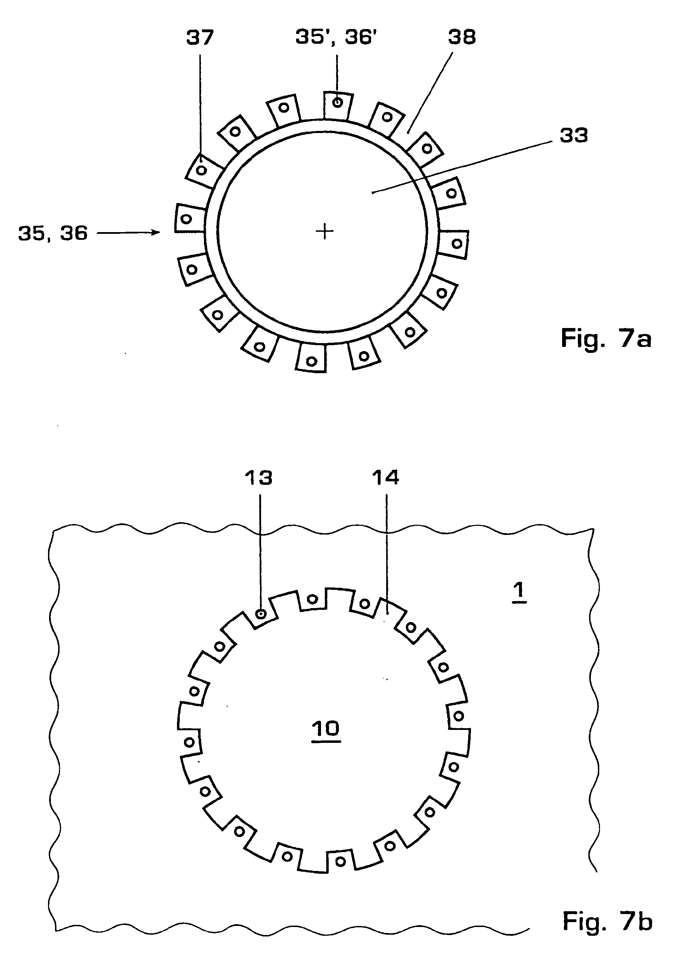

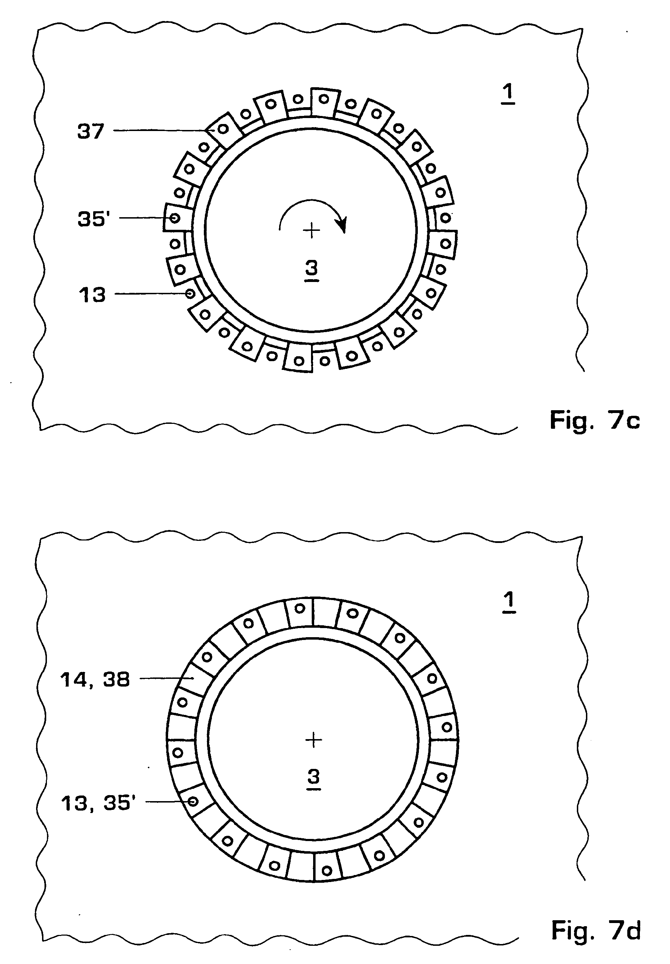

Um den niederinduktiven Weg durch die Mehrfachlayer der Platine um den Thyristor 3 herum nicht zu stören, werden in bevorzugten Ausführungsformen der Erfindung zusätzliche Montagemittel vorgeschlagen.. Ein erstes bevorzugtes Ausführungsbeispiel für diese Montagemittel ist in den Fig. 7ad gezeigt, wobei Fig. 7a und 7b die Montagemittel an sich und Fig. 7c und 7d deren Einsatz und Wirkung zeigen. Bei dem ersten Ausführungsbeispiel sind gemäss Fig. 7a der Hilfskathodenanschluss 36 und/oder der Gateanschluss 35 in eine Mehrzahl von über den Umfang verteilt angeordneten, durch erste Aussparungen 38 untereinander getrennten Segmenten 37 unterteilt. Weiterhin umfasst die Montageöffnung 10 gemäss Fig. 7b über den inneren Umfang verteilt angeordnete und nach Anzahl und Abmessungen den Segmenten 37 der Anschlüsse 35, 36 entsprechende, segmentförmige zweite Aussparungen 14.

Gemäss Fig. 7c kann nun der Thyristor 3 mit der Gehäuseachse 39 senkrecht zur Anschlussplatine 1 orientiert in die Montageöffnung 10 eingesteckt werden, wobei die Segmente 37 jeweils durch die entsprechenden Aussparungen 14 in der Anschlussplatine 1 hindurchgesteckt werden. Durch eine anschliessende Drehung um die Gehäuseachse 39 (Pfeil in Fig. 7c) kann der Thyristor 3 dann in seine endgültige Anschlussposition gebracht werden, wobei die Segmente 37 unter bzw. über den Bereichen zwischen den Aussparungen 14 der Anschlussplatine 1 zu liegen kommen. In den einzelnen Segmenten 37 und in den zwischen den Aussparungen 14 der Anschlussplatine 1 liegenden Bereichen ist jeweils wenigstens ein Schraubloch 35',36' bzw. eine Befestigungsbohrung 13 zum Verschrauben des Gateanschlusses 35 bzw. des Hilfskathodenanschlusses 36 mit der Anschlussplatine 1 vorgesehen, die in der Anschlussposition übereinander liegen.

Die Segmentierung der Anschlüsse 35 und 36 kann auf unterschiedliche Weise erfolgen: Ist nur der Hilfskathodenanschluss 36 segmentiert, muss der Thyristor 3 von oben durch die Montageöffnung 10 gesteckt werden. Ist nur der Gateanschluss 35 segmentiert, muss der Thyristor 3 von unten in die Montageöffnung 10 gesteckt werden. Sind dagegen beide Anschlüsse 35 und 36 segmentiert, kann das Durchstecken des Thyristors 3 wahlweise von oben oder von unten erfolgen. Bevorzugt weisen die Segmente 37 und die ersten Aussparungen 38 im wesentlichen dieselben Abmessungen auf. Hierdurch wird die Anschlussfläche zwischen Anschlussplatine 1 und den Segmenten 37 maximiert und die Induktivität minimiert. Die Anzahl der Segmente 37 kann unterschiedlich gross gewählt werden. Im gezeigten Ausführungsbeispiel beträgt sie 16. Der Thyristor 3 muss in diesem Fall (Fig. 7c, 7d) um 360°/32 oder 11,25° um die Gehäuseachse 39 gedreht werden, um von der Einsteckposition (Fig. 7c) in die Anschlussposition (Fig. 7d) zu gelangen. Die Verteilung der Segmente 37 über den Umfang sollte aus Gründen der Induktivität gleichmässig sein, kann aber in Sonderfällen (aus Platzgründen oder dgl.) auch ungleichmässig gewählt werden.

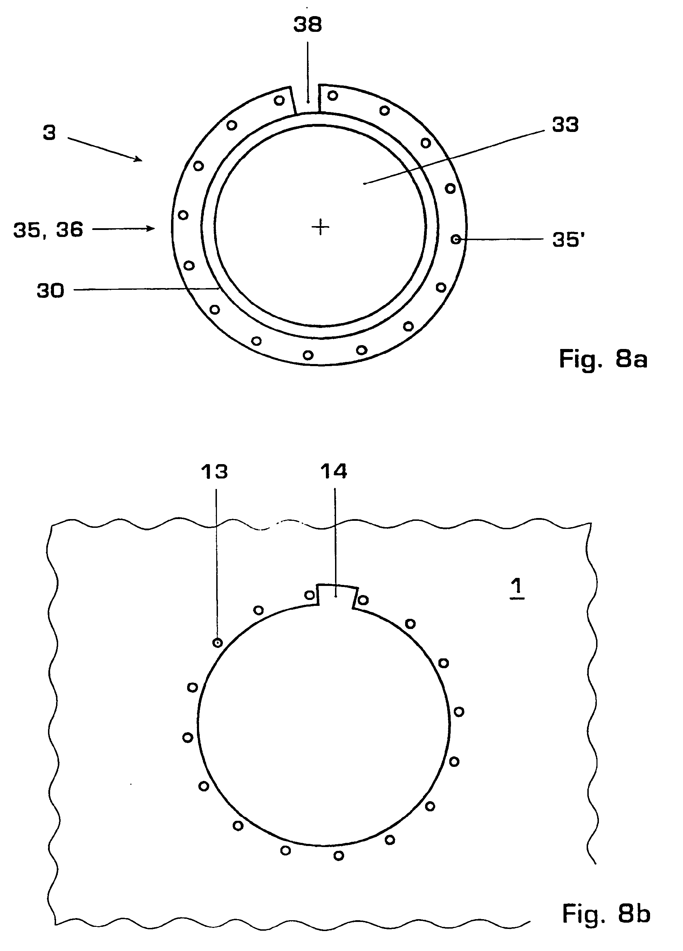

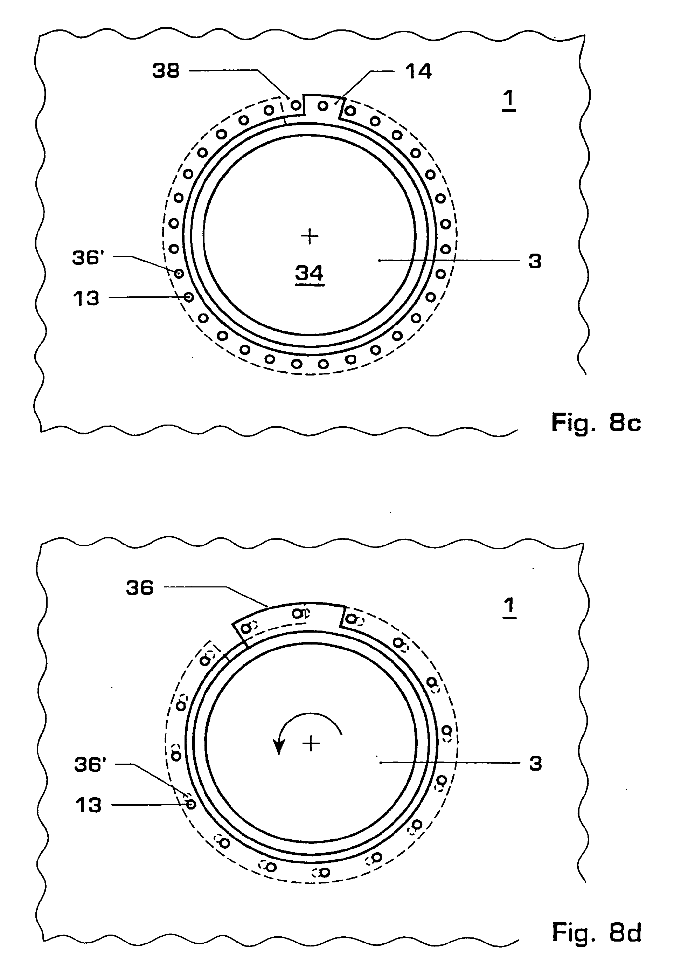

Im Ausführungsbeispiel der Fig. 7a-7d, bei dem sich an den Anschlüssen 35, 36 gleich grosse Segmente 37 und Aussparungen 38 abwechseln, steht für den eigentlichen Anschluss an die Platine 1 nur die Hälfte der ursprünglichen Ringfläche zur Verfügung. Eine wesentlich grössere Anschlussfläche lässt sich erreichen, wenn die Montagemittel gemäss dem in Fig. - 8a-8d gezeigten zweiten Ausführungsbeispiel ausgebildet sind. In diesem Fall ist der Hilfskathodenanschluss 36 und/oder der Gateanschluss 35 an seinem Umfang durch nur eine segmentförmige erste Aussparung 38 unterbrochen (Fig. 8a). Die Montageöffnung 10 weist an ihrem inneren Umfang ebenfalls nur eine segmentförmige zweite Aussparung 14 auf (Fig. 8b). Das Einsetzen des Thyristors 3 in die Montageöffnung 10 erfolgt gemäss Fig. 8c (Draufsicht von unten; der Thyristor 3 wird von oben in die Montageöffnung 10 eingesetzt) nun so, dass der Anfang des Hilfskathodenanschlusses 36 am Rande der Aussparung 38 in der Aussparung 14 zu liegen kommt. Der Thyristor 3 wird dann mit der Gehäuseachse 39 gekippt, so dass der Anfang des Hilfskathodenanschlusses 36 durch die Aussparung 14 hindurch unter die Anschlussplatine 1 geschoben werden kann. Nach diesem "Einfädeln" bzw. Verschränken kann der Thyristor 3 mit schiefstehender Gehäuseachse 39 schraubenartig in die Montageöffnung 10 eingedreht werden (Fig. 8d), wobei der Hilfskathodenanschluss 36 mit zunehmender Drehung über eine grösser werdende Länge auf die Unterseite der Platine gelangt und sich vollständig darunter befindet, wenn die Drehung nahezu 360° vollendet hat.

Auch in diesem Fall ist auf dem Hilfskathodenanschluss 36 und auf dem Gateanschluss 35 sowie um die Montageöffnung 10 herum auf dem Umfang verteilt eine Mehrzahl von zueinander passenden Schraublöchern 35', 13 zum Verschrauben des Gateanschlusses 35 bzw. des Hilfskathodenanschlusses 36 mit der Anschlussplatine 1 vorgesehen. Auch in diesem Fall kann die Aussparung 38 wahlweise an dem Hilfskathodenanschluss 36, am Gateanschluss 35, oder an beiden Anschlüssen vorhanden sein.

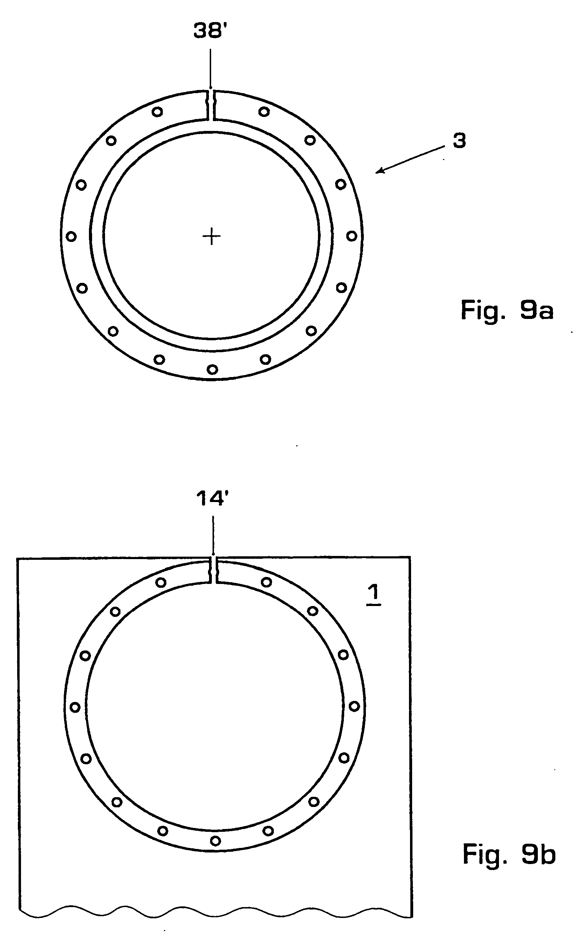

In den Figuren 9a und 9b ist eine weitere Ausführungsform dargestellt, welche eine grosse Anschlussfläche ermöglicht. Anstelle von segmentförmigen Aussparungen sind nun schmale Schlitze 38',14' vorhanden. Dabei reicht es im Falle des Thyristors 3 aus, dass lediglich in einem Flansch, hier im Hilfskathodenanschluss ein Schlitz 38' vorhanden ist. Die Anschlussplatine 1 weist ebenfalls einen Schlitz 14' auf, welcher sich bis an den Platinenrand erstreckt. Die Montage erfolgt wie bei der anhand der Figuren 8a-8d beschriebenen Variante. In dieser Ausführungsform ist jedoch vorteilhaft, dass Montageöffnung, 10 wie auch die Anschlüsse 35,36 einen fast intakten Kreis bilden, so dass die Gatestromsteilheit maximiert ist.

In allen drei gezeigten Ausführungsbeispielen kommt der Gateanschluss 35 des Thyristors 3 direkt auf der Anschlussplatine 1 und der Hilfskathodenanschluss 36 direkt unter der Platine zu liegen. Selbstverständlich ist aber auch die entgegengesetzte Positionierung (Hilfskathodenanschluss 36 oben, Gateanschluss 35 unten) möglich und für spezielle Montagefälle auch vorteilhaft. Weiterhin können statt 16 Schraublöchern 35', 13 auch jede andere Anzahl gewählt werden. 12 bis 16 Schrauben ergeben jedoch einen besonders guten Kontakt, wie er im Falle eines Hochstrom-GCT (z.B. mit 5-6 kA Abschaltvermögen in einem Gehäuse 30 mit 1120 mm Durchmesser) benötigt wird.

Insgesamt ergibt sich mit der Erfindung ein niederinduktiv angesteuerter GCT, der sich durch einen einfachen Aufbau und eine einfache Montage auszeichnet, besonders für hohe Ströme und Leistungen geeignet ist, und eine ungestörte thermische Ankopplung des Bauelements bei unverändert niedriger Anschlussinduktivität ermöglicht.

### BEZEICHNUNGSLISTE

- HT: Halbleiterbauteil
- GE: Gateeinheit

- 1: Anschlussplatine
- 10: Montageöffnung
- 10': konkaver Einschnitt
- 11: erste halbkreisförmige Kontaktfläche
- 12: zweite halbkreisförmige Kontaktfläche
- 13: Befestigungsbohrungen
- 14: zweite segmentförmige Aussparung
- 14': Schlitz
- 1': Anschlussplatte

- 2: elektrische Bauteile

- 3: gategesteuerter Thyristor (GCT)
- 30: Gehäuse
- 31: Halbleitersubstrat
- 32: Molybdänscheibe
- 33: Anode
- 34: Kathode
- 35: Gateanschluss
- 35': Schraubloch
- 36: Hilfskathodenanschluss
- 36': Schraubloch
- 37: Segment
- 38: erste segmentförmige Aussparung
- 38': Schlitz
- 39: Gehäuseachse

- 4: Befestigungsschrauben

## Patentansprüche

1. Halbleiterbauelement (3), insbesondere ein Thyristor, mit einem Halbleitersubstrat (31), welches in einem im wesentlichen zylindrischen Gehäuse (30) angeordnet ist, einer Anode (33) und einer Kathode (34) und einem seitlich aus dem Gehäuse (30) herausragenden, das Gehäuse (30) konzentrisch umgebenden, kreisringförmigen Gateanschluss (35), **dadurch gekennzeichnet,**
**dass** ein parallel zum Gateanschluss (35) über das Gehäuse (30) hinausragender, das Gehäuse (30) konzentrisch umgebender, kreisringförmiger Hilfskathodenanschluss (36) zur Kontaktierung einer Hilfskathode vorhanden ist.

2. Halbleiterbauelement nach Anspruch 1, **dadurch gekennzeichnet, dass** das Gehäuse (30) auf der einen Stirnseite die Anode (33) und auf der anderen Stirnseite die Kathode (34) umfasst, und dass in einer ersten Ebene zwischen Anode und Kathode der Gateanschluss (35) und in einer zweiten Ebene zwischen Anode und Kathode der Hilfskathodenanschluss (36) angeordnet sind

3. Halbleiterbauelement nach Anspruch 1, **dadurch gekennzeichnet, dass** der Gateanschluss (35) und der Hilfskathodenanschluss(36) mindestens annähernd denselben Aussenradius aufweisen.

4. Halbleiterbauteil mit einer Anschlussplatine (1) und einem Halbleiterbauelement (3) nach Anspruch 2,
**dadurch gekennzeichnet, dass** das Halbleiterbauelement (3) zur niederinduktiven Verbindung mit einer auf der Anschlussplatine (1) untergebrachten Ansteuerschaltung in einer Montageöffnung (10) in der Anschlussplatine (1) angeordnet ist, derart, dass
der Gateanschluss (35) auf der einen Seite der Anschlussplatine (1) parallel zur Anschlussplatine (1) zu liegen kommt und über den Rand der Montageöffnung (10) hinausragt und dort an die eine Seite der Anschlussplatine (1) angeschlossen ist, dass
die Kathode (34) auf die andere Seite der Anschlussplatine (1) zu liegen kommt und über den Hilfskathodenanschluss (36) an die andere Seite der Anschlussplatine angeschlossen ist, und dass
der Hilfskathodenanschluss (36) über den Rand der Montageöffnung (10) hinausragt.

5. Halbleiterbauteil nach Anspruch 4, **dadurch gekennzeichnet, dass** die Montageöffnung (10) durch einen konkaven, halbkreisförmigen Einschnitt in die Anschlussplatine (1) gebildet ist.

6. Halbleiterbauteil nach Anspruch 4, **dadurch gekennzeichnet, dass** an der Montageöffnung (10) und am Hilfskathodenanschluss (36) und/oder am Gateanschluss (35) Mittel (37, 38, 38; 38, 38) vorhanden sind, welche das Einsetzen des Halbleiterbauelementes (3) in die Montageöffnung (10) ohne Veränderung am Halbleiterbauelement bzw. der Anschlussplatine (1) ermöglichen.

7. Halbleiterbauteil nach Anspruch 6, **dadurch gekennzeichnet, dass** die Mittel (37, 38, 38) so ausgebildet sind, dass das Halbleiterbauelement (3) mit der Gehäuseachse (39) senkrecht zur Anschlussplatine (1) orientiert in die Montageöffnung (10) einsteckbar und durch eine Drehung um die Gehäuseachse (39) in die Anschlussposition bringbar ist.

8. Halbleiterbauteil nach Anspruch 7, **dadurch gekennzeichnet, dass** der Hilfskathodenanschluss (36) und/oder der Gateanschluss (35) in eine Mehrzahl von über den Umfang verteilt angeordneten, durch erste Aussparungen (38) untereinander getrennten Segmenten (37) unterteilt ist, und dass die Montageöffnung (10) über den inneren Umfang verteilt angeordnete und nach Anzahl und Abmessungen den Segmenten (37) entsprechende, segmentförmige zweite Aussparungen (38) umfasst.

9. Halbleiterbauteil nach Anspruch 8, **dadurch gekennzeichnet, dass** die Segmente (37) und die ersten Aussparungen (38) im wesentlichen dieselben Abmessungen aufweisen.

10. Halbleiterbauteil nach Anspruch 6, **dadurch gekennzeichnet, dass** die Mittel (38, 38) so ausgebildet sind, dass das Halbleiterbauelement (3) mit schräg zur Anschlussplatine (1) orientierter Gehäuseachse (39) in die Montageöffnung (10) eindrehbar ist.

11. Halbleiterbauteil nach Anspruch 10, **dadurch gekennzeichnet, dass** der Hilfskathodenanschluss (36) und/oder der Gateanschluss (35) an seinem Umfang wenigstens eine segmentförmige erste Aussparung (38) aufweist, und dass die Montageöffnung (10) an ihrem inneren Umfang wenigstens eine segmentförmige zweite Aussparung (38) aufweist.

12. Halbleiterbauteil nach Anspruch 10, **dadurch gekennzeichnet, dass** der Hilfskathodenanschluss (36) und/oder der Gateanschluss (35) an seinem Umfang eine schlitzförmige erste Aussparung (38) aufweist, und dass die Montageöffnung (10) eine schlitzförmige zweite Aussparung (38) aufweist, welche sich bis zu einem Platinenrand erstreckt.

## Claims

1. Semiconductor component (3), in particular a thyristor, having a semiconductor substrate (31) arranged in an essentially cylindrical housing (30), an anode (33) and a cathode (34) and an annular gate connection (35), which projects laterally from the housing (30) and concentrically surrounds the housing (30), **characterized in that** an annular auxiliary cathode connection (36) for making contact with an auxiliary cathode is present, which projects beyond the housing (30) parallel to the gate connection (35) and concentrically surrounds the housing (30).

2. Semiconductor component according to Claim 1, **characterized in that** the housing (30) comprises the anode (33) on one end and the cathode (34) on the other end, and **in that** the gate connection (35) is arranged in a first plane between anode and cathode and the auxiliary cathode connection (36) is arranged in a second plane between anode and cathode.

3. Semiconductor component according to Claim 1, **characterized in that** the gate connection (35) and the auxiliary cathode connection (36) have at least approximately the same external radius.

4. Semiconductor device having a connection board (1) and a semiconductor component (3) according to Claim 2, **characterized in that** the semiconductor component (3), for low-inductance connection to a drive circuit accommodated on the connection board (1), is arranged in a mounting opening (10) in the connection board (1), in such a way that
the gate connection (35) is located parallel to the connection board (1) on one side of the connection board (1) and projects beyond the edge of the mounting opening (10) and is connected there to said one side of the connection board (1), that
the cathode (34) is located on the other side of the connection board (1) and is connected to said other side of the connection board via the auxiliary cathode connection (36), and that
the auxiliary cathode connection (36) projects beyond the edge of the mounting opening (10).

5. Semiconductor device according to Claim 4, **characterized in that** the mounting opening (10) is formed by a concave, semicircular incision in the connection board (1).

6. Semiconductor device according to Claim 4, **characterized in that** means (37, 38, 38; 38, 38) are present on the mounting opening (10) and on the auxiliary cathode connection (36) and/or on the gate connection (35), which means enable the semiconductor component (3) to be inserted into the mounting opening (10) without any alteration to the semiconductor component and/or the connection board (1).

7. Semiconductor device according to Claim 6, **characterized in that** the means (37, 38, 38) are designed in such a way that the semiconductor component (3) can be inserted into the mounting opening (10) with the housing axis (39) oriented perpendicular to the connection board (1) and can be brought into the connection position by rotation about the housing axis (39).

8. Semiconductor device according to Claim 7, **characterized in that** the auxiliary cathode connection (36) and/or the gate connection (35) are/is subdivided into a plurality of segments (37), which are arranged such that they are distributed over the circumference and are separated from one another by first cutouts (38), and **in that** the mounting opening (10) comprises second cutouts (38) in segment form, which are arranged such that they are distributed over the inner circumference and the number and dimensions of which correspond to those of the segments (37).

9. Semiconductor device according to Claim 8, **characterized in that** the segments (37) and the first cutouts (38) have essentially the same dimensions.

10. Semiconductor device according to Claim 6, **characterized in that** the means (38, 38) are designed in such a way that the semiconductor component (3) can be screwed into the mounting opening (10) with the housing axis (39) oriented in an inclined manner with respect to the connection board (1).

11. Semiconductor device according to Claim 10, **characterized in that** the auxiliary cathode connection (36) and/or the gate connection (35) has at least one first cutout (38) in segment form on its circumference, and **in that** the mounting opening (10) has at least one second cutout (38) in segment form on its inner circumference.

12. Semiconductor device according to Claim 10, **characterized in that** the auxiliary cathode connection (36) and/or the gate connection (35) has a first cutout (38) in slot form on its circumference, and **in that** the mounting opening (10) has a second cutout (38) in slot form, which extends as far as a board edge.

## Revendications

1. Composant semiconducteur (3), notamment thyristor, comprenant un substrat en semiconducteur (31) qui est disposé dans un boîtier (30) essentiellement cylindrique, une anode (33) et une cathode (34) et une borne de gâchette (35) de forme annulaire faisant saillie latéralement du boîtier (30) et entourant le boîtier (30) de manière concentrique, **caractérisé en ce qu'**il existe une borne de cathode auxiliaire (36) de forme annulaire faisant saillie du boîtier (30) parallèlement à la borne de gâchette (35) et entourant le boîtier (30) de manière concentrique pour établir le contact avec une cathode auxiliaire.

2. Composant semiconducteur selon la revendication 1, **caractérisé en ce que** le boîtier (30) comprend l'anode (33) d'un côté frontal et la cathode (34) de l'autre côté frontal et que la borne de gâchette (35) est disposée dans un premier plan entre l'anode et la cathode et la borne de cathode auxiliaire (36) dans un deuxième plan entre l'anode et la cathode.

3. Composant semiconducteur selon la revendication 1, **caractérisé en ce que** la borne de gâchette (35) et la borne de cathode auxiliaire (36) présentent au moins approximativement le même rayon extérieur.

4. Module semiconducteur comprenant une platine de raccordement (1) et un composant semiconducteur (3) selon la revendication 2, **caractérisé en ce que** le composant semiconducteur (3) est disposé dans une ouverture de montage (10) dans la platine de raccordement (1) en vue de réaliser une liaison à basse induction avec un circuit d'excitation monté sur la platine de raccordement (1) de telle sorte que la borne de gâchette (35) vient reposer parallèlement à la platine de raccordement (1) de l'un côté de la platine de raccordement (1) et dépasse au-dessus du bord de l'ouverture de montage (10) et y est raccordée à un côté de la platine de raccordement (1), que la cathode (34) vient reposer de l'autre côté de la platine de raccordement (1) et est raccordée de l'autre côté de la platine de raccordement par le biais de la borne de cathode auxiliaire (36) et que la borne de cathode auxiliaire (36) dépasse au-dessus du bord de l'ouverture de montage (10).

5. Module semiconducteur selon la revendication 4, **caractérisé en ce que** l'ouverture de montage (10) est formée par une découpe concave en forme de demi-cercle dans la platine de raccordement (1).

6. Module semiconducteur selon la revendication 4, **caractérisé en ce qu'**il existe au niveau de l'ouverture de montage (10) et sur la borne de cathode auxiliaire (36) et/ou la borne de gâchette (35) des moyens (37, 38, 38 ; 38, 38) qui permettent l'insertion du composant semiconducteur (3) dans l'ouverture de montage (10) sans modifier le composant semiconducteur ni la platine de raccordement (1).

7. Module semiconducteur selon la revendication 6, **caractérisé en ce que** les moyens (37, 38, 38) sont configurés de telle sorte que le composant semiconducteur (3) avec l'axe de boîtier (39) peut être inséré dans l'ouverture de montage (10) perpendiculairement par rapport à la platine de raccordement (1) et peut être amené en position de raccordement par une rotation autour de l'axe du boîtier (39).

8. Module semiconducteur selon la revendication 7, **caractérisé en ce que** la borne de cathode auxiliaire (36) et/ou la borne de gâchette (35) est divisée en une pluralité de segments (37) distribués sur le pourtour et séparés entre eux par des premiers creux (38) et que l'ouverture de montage (10) comprend des deuxièmes creux (38) en forme de segments, distribués sur le pourtour intérieur et dont le nombre et les dimensions correspondent à ceux des segments (37).

9. Module semiconducteur selon la revendication 8, **caractérisé en ce que** les segments (37) et les premiers creux (38) présentent pour l'essentiel les mêmes dimensions.

10. Module semiconducteur selon la revendication 6, **caractérisé en ce que** les moyens (38, 38) sont configurés de telle sorte que le composant semiconducteur (3) peut être inséré par rotation dans l'ouverture de montage (10) avec l'axe du boîtier (39) orientée en biais par rapport à la platine de raccordement (1).

11. Module semiconducteur selon la revendication 10, **caractérisé en ce que** la borne de cathode auxiliaire (36) et/ou la borne de gâchette (35) présente sur son pourtour au moins un premier creux (38) en forme de segment et que l'ouverture de montage (10) présente sur son pourtour intérieur au moins un deuxième creux (38) en forme de segment.

12. Module semiconducteur selon la revendication 10, **caractérisé en ce que** la borne de cathode auxiliaire (36) et/ou la borne de gâchette (35) présente sur son pourtour un premier creux (38) en forme de fente et que l'ouverture de montage (10) présente un deuxième creux (38) en forme de fente qui s'étend jusqu'à un bord de la platine.
